# FASCICULE DE BREVET EUROPEEN

(11) **EP 0 616 724 B1**
(45) Date de publication et mention de la délivrance du brevet: **24.09.1997**
(21) Numéro de dépôt: 93913141.3
(22) Date de dépôt: 16.06.1993
(51) Int. Cl.: H01L 23/12, H01L 23/16, H01L 31/0203

(54) **COMPOSANT ELECTRONIQUE ET PROCEDE DE FABRICATION**
ELEKTRONISCHES BAUELEMENT UND DESSEN HERSTELLUNGSVERFAHREN
ELECTRONIC DEVICE AND PRODUCTION METHOD THEREFOR

(30) Priorité: 19.06.1992 FR 9207482
(43) Date de publication de la demande: 28.09.1994
(73) Titulaire: THOMSON-CSF SEMICONDUCTEURS SPECIFIQUES, 75008 Paris (FR)
(72) Inventeur: PROST, Roger, F-92402 Courbevoie Cédex (FR)
(74) Mandataire: Guérin, Michel
(86) Numéro de dépôt international: FR9300586
(87) Numéro de publication internationale: WO9400879

(56) Documents cités:
- DD-A- 244 671
- US-A- 4 715 115
- 11TH IEEE/CHMT INTERNATIONAL ELECTRONICS MANUFACTURING TECHNOLOGY SYMPOSIUM, SAN FRANCISCO, CA, US, 16-18 SEPT. 1991 pages 175 - 180 Y.NAKATSUKA ET AL. 'Development of fine pitch and high lead count ceramic QFP'
- PATENT ABSTRACTS OF JAPAN vol. 11, no. 7 (E-469)(2454) 9 Janvier 1987 & JP,A,61 183 957
- PATENT ABSTRACTS OF JAPAN vol. 12, no. 38 (E-580)4 Février 1988 & JP,A,62 190 856

## Description

L'invention concerne les composants électroniques, en particulier les senseurs pyroélectriques, c'est-à-dire des dispositifs capables de fournir un signal électrique représentant le rayonnement thermique (infrarouge principalement) d'un corps placé devant le senseur. L'invention concerne notamment les senseurs matriciels fournissant des signaux électriques représentant une image thermique d'un corps rayonnant placé devant le senseur ou d'un paysage rayonnant observé par le senseur.

Pour réaliser de tels senseurs on tend à utiliser maintenant des matériaux pyroélectriques déposés en couche mince sur un substrat de silicium. Le matériau pyroélectrique, lui-même revêtu d'une couche absorbant les rayons infrarouge, s'échauffe et engendre des quantités de charges électriques dépendant de cet échauffement; les charges sont reproduites, par couplage capacitif, dans le silicium; des signaux électriques sont ainsi produits dans le silicium et sont traités par des circuits réalisés selon la technologie des circuits intégrés à semiconducteurs, plus précisément des circuits à transfert de charges.

Les matériaux pyroélectriques qu'on utilise sont de préférence ceux qui peuvent être déposés en couches très minces sur des substrats de silicium et ces matériaux présentent malheureusement l'inconvénient d'être fortement piézoélectriques, c'est-à-dire qu'ils engendrent des charges électriques lorsqu'ils subissent des déformations mécaniques. Ces charges s'ajoutent ou se retranchent aux charges engendrées par l'effet pyroélectrique qu'on cherche à détecter; elles perturbent fortement le signal utile émis par le senseur. Les déformations mécaniques résultent de l'environnement et sont transmises à la couche pyroélectrique par l'intermédiaire du substrat de silicium et des divers éléments constituant le boîtier du composant.

Pour limiter l'influence néfaste des déformations ou des vibrations transmises à la couche pyroélectrique, on a déjà proposé de "mosaïquer" la couche pyroélectrique, c'est-à-dire de la diviser en zones de détection élémentaires séparées les unes des autres. Les zones de détection sont alors de très petites dimensions et sont beaucoup moins sensibles aux déformations transmises par le boîtier. Mais cette solution ne paraît pas suffisante et est difficile à mettre en oeuvre.

On peut aussi envisager de monter le composant sur un support très rigide, tel qu'une pastille de céramique de plus d'un centimètre d'épaisseur. La puce de silicium recouverte de matériau pyroélectrique est montée dans un boîtier ayant des pattes de sortie métalliques rigides, et le boîtier est fixé sur le support épais rigide. Le composant est alors raccordé à l'extérieur (raccordement à un circuit imprimé) par des nappes de fils souples. La rigidité du support épais du composant et la connexion par fils souples permettent de bien protéger la couche pyroélectrique contre les déformations du boîtier; mais elle présente de gros inconvénients pratiques : d'une part l'ensemble du composant encapsulé dans un boîtier va présenter une hauteur nettement plus élevée que la hauteur standard, ce qui empêchera son utilisation dans beaucoup d'applications. D'autre part, une connexion par nappes de fils est une connexion non standardisée qui complique nettement le montage des cartes électroniques utilisant le composant.

On pourrait également penser à placer sous le boîtier, à la place du bloc de céramique épais et rigide, une plaquette de matériau souple, mince, empêchant la transmission de déformations; mais il subsiste le problème du raccordement du composant qui devra encore se faire par une nappe de fils souples; une connexion classique par pattes soudées à une carte de circuit imprimé risquerait en effet de transmettre les déformations mécaniques de la carte jusqu'à la couche de matériau pyroélectrique ; et de plus, la fixation du composant sur un circuit imprimé par l'intermédiaire d'une feuille souple poserait des problèmes délicats.

En dehors de ces solutions qui ont été spécialement étudiées pour résoudre le problème délicat des composants pyroélectriques (erreurs de signal importantes même pour des contraintes faibles exercées sur le boîtier), on trouve évidemment aussi dans l'art antérieur des montages destinés à protéger mécaniquement un composant fragile à l'intérieur d'un boîtier.

Par exemple, dans l'art antérieur relatif aux composants semiconducteurs, on a déjà proposé des structures de protection contre les contraintes dans le cas de l'intégration de tranches entières de silicium de plusieurs dizaines de centimètres carrés de surface ("Wafer Scale Integration"). Ces tranches sont très fragiles et risquent de se briser lorsque leur surface arrière et la surface de l'embase sur lesquelles elles reposent présentent des imperfections de planéité : un liquide est alors interposé entre la tranche et le fond pour compenser ces imperfections, et un bloc élastique, appuyé contre le haut du boîtier maintient la puce contre le liquide. La présence de liquide n'empêche cependant pas la transmission de contraintes et de vibrations à la tranche. Le brevet US-A-4 715 115 décrit une telle structure.

D'autres solutions consistent par exemple à noyer la puce semiconductrice dans une résine. Mais il semble que dans tous les cas la puce repose directement sur le fond du boîtier, ou en tous cas elle n'est pas isolée du boîtier du point de vue de la transmission des contraintes et des vibrations. L'article de Y. Nakatsuka et Al. "Development of ...", 11th IEEE/CHMT TECH. SYMP. 1991, pages 175-180 décrit par exemple une structure dans laquelle la puce est solidaire rigidement par sa face arrière, du boîtier (embase ou capot).

Pour résoudre au mieux les problèmes engendrés par la piézoélectricité naturelle de la couche de matériau pyroélectrique du senseur, on propose selon l'invention d'intercaler, entre la puce portant la couche et le boîtier portant les connexions extérieures du composant, une couche d'un matériau déformable élastiquement capable d'absorber sans les transmettre la majeure partie des déformations, contraintes, et vibrations, du boîtier, la puce étant raccordée au boîtier par l'intermédiaire de fils de connexion souples soudés; la puce n'est par ailleurs pas collée, ni soudée directement au boîtier, ni reliée à celui-ci par un élément qui serait lui-même couplé au boîtier d'une manière telle que les vibrations et contraintes subies par le boîtier seraient transmises à la puce. Des moyens sont prévus pour permettre une soudure des fils de connexion sans qu'on soit gêné par la présence de la couche déformable.

La couche déformable peut être une feuille souple mince. La hauteur globale du composant ne sera pratiquement pas affectée par la présence de cette feuille mince. Le boîtier peut par ailleurs être de type standard (boîtier céramique multicouche notamment) et ses connexions de sortie sont des connexions standard rigides, à souder sur une carte de circuit imprimé.

De préférence, les moyens pour permettre de souder les fils de connexion de la puce à l'intérieur du boîtier comportent une plaquette de céramique mince sur laquelle est collée ou soudée la puce par sa face arrière, cette plaquette reposant sur la couche déformable, la plaquette débordant latéralement par rapport à la puce pour qu'un outil puisse prendre appui sur la plaquette pendant l'opération de soudure. De préférence, des butées sont prévues au fond du boîtier pour limiter l'écrasement de la couche déformable ou de la feuille souple pendant l'opération de soudure, la plaquette venant prendre appui sur ces butées au delà d'une certaine pression exercée par l'outil au moment de la soudure.

Indépendamment de l'utilité qu'elle présente pour faciliter la soudure des fils de connexion, cette plaquette rigide sur laquelle est collée la puce présente l'intérêt de constituer un ensemble plus rigide, donc d'autant mieux découplé par rapport aux contraintes subies par le boîtier. La tension exercée par la plaquette rigide sur la puce établit des contraintes fixes et bien contrôlées sur la puce, ce qui est favorable pour la stabilité du signal pyroélectrique dans le cas d'un composant pyroélectrique.

On peut également envisager que les moyens pour souder les fils de connexion de la puce consistent simplement dans la nature du matériau souple déformable : on choisit un matériau qui devient rigide au dessous d'une certaine température et on refroidit le composant jusqu'à cette température pendant l'opération de soudure de sorte qu'on n'est pas gêné pendant cette opération par la souplesse du matériau.

En général les matériaux à base de silicone conviennent bien. La feuille souple peut être trouée par endroits si on désire augmenter sa souplesse. La répartition et les dimensions des trous permettent d'ajuster l'aptitude de la feuille à être déformée, pour un type de matériau et une épaisseur donnée.

Un autre aspect sous lequel il faut envisager l'invention est celui du procédé de fabrication d'un senseur pyroélectrique : ce procédé est caractérisé en ce qu'on intercale une feuille de matériau souple entre une puce recouverte d'une couche pyroélectrique et un boîtier; puis on soude des fils de connexion entre la puce et le boîtier. Dans l'art antérieur on a toujours considéré qu'il fallait placer la puce sur un support rigide avant d'effectuer la soudure des fils.

L'invention est principalement destinée à réaliser des senseurs pyroélectriques en raison du problème très spécifique que pose la forte sensiblilité piézoélectrique de la couche pyroélectrique, mais on comprendra qu'elle peut aussi s'appliquer par extension à d'autres composants présentant des problèmes de même nature, c'est-à-dire dans lesquels les déformations de la puce peuvent perturber le fonctionnement du dispositif d'une manière très gênante.

D'autres caractéristiques et avantages de l'invention apparaîtront à la lecture de la description détaillée qui suit et qui est faite en référence aux dessins annexés dans lesquels :
- la figure 1 représente à titre d'exemple la constitution d'une puce formant le coeur d'un senseur pyroélectrique monolithique ;
- la figure 2 représente un montage classique de puce dans un boîtier céramique;
- la figure 3 représente un montage de senseur pyroélectrique monolithique en boîtier céramique selon un mode de réalisation préféré de l'invention.

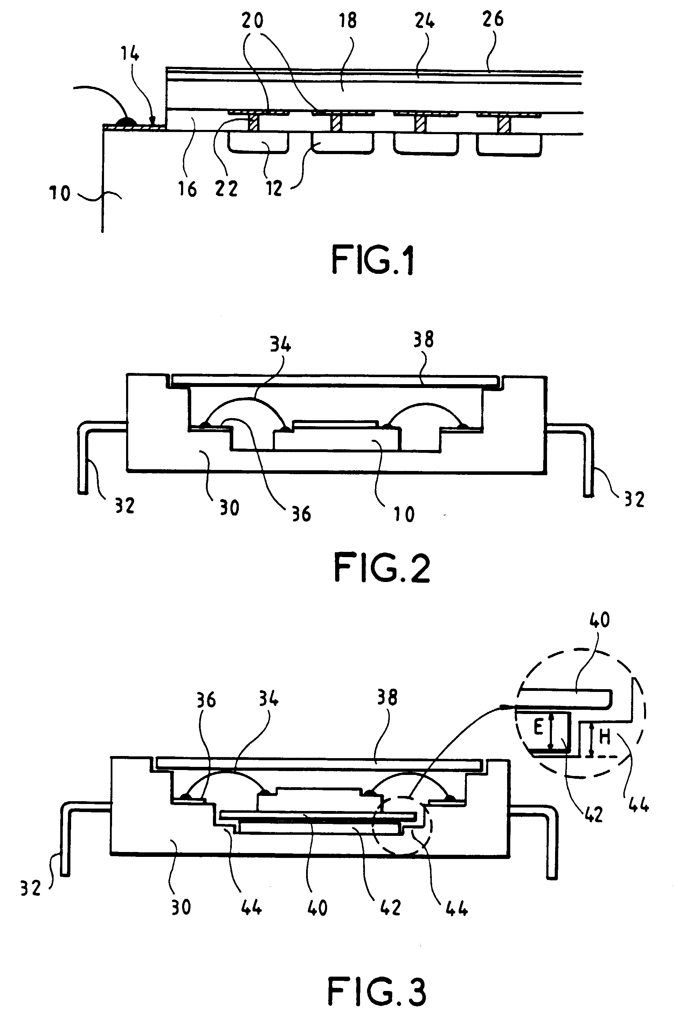

La figure 1 représente schématiquement la constitution d'une puce semiconductrice constituant un senseur pyroélectrique monolithique. Des détails sur la constitution interne d'un tel senseur monolithique peuvent être trouvés dans la demande de brevet FR 90 15 476.

La puce comporte essentiellement un substrat de silicium 10 dans lequel sont formés, selon les technologies usuelles en matière de circuit intégrés à transfert de charge, les circuits de lecture et de transmission des charges électriques engendrées par effet pyroélectrique dans chaque zone élémentaire d'image du senseur. Ces circuits de lecture 12, représentés d'une manière symbolique, comportent des diodes, des électrodes isolées du substrat, des registres à transfert de charges, des connexions, etc., et enfin des plots de contact pour la transmission de signaux vers l'extérieur de la puce ou pour la transmission de tensions d'alimentation de l'extérieur vers la puce.

Les plots de contact sont désignés par la référence 14.

La puce est recouverte, en dehors des plots de contact 14, par une couche isolante 16, en général du polyimide d'une dizaine de micromètres d'épaisseur. Cette couche est elle-même recouverte d'une couche pyroélectrique 18, et des électrodes inférieures 20 sont interposées localement (une électrode inférieure par point d'image) entre la couche isolante 16 et la couche pyroélectrique 18. Des traversées conductrices 22 sont prévues de place en place à travers la couche 16 pour relier chaque électrode inférieure à un circuit de lecture 12 correspondant.

La couche pyroélectrique peut être mosaïquée, c'est-à-dire divisée en carrés élémentaires correspondant à chaque point image, ou être uniforme.

Une électrode supérieure 24, par exemple en aluminium, permet de définir le potentiel de la surface supérieure de la couche pyroélectrique.

Enfin, une couche 26, absorbante pour les rayons infrarouge, est déposée en surface de la couche pyroélectrique (si cette couche est conductrice, elle peut servir d'électrode supérieure). Cette couche 26 est par exemple en aluminium noir, ou chrome noir ou titane noir.

La couche pyroélectrique est en matériau à faible conductivité thermique (inférieur à 1 W/m.°K ou même 0,2 W/m.°K), par exemple du PVFD ou un matériau composite pyroélectrique comprenant une charge minérale dans un polyimide. L'épaisseur de la couche peut être d'environ 10 micromètres.

Cette description est donnée à titre indicatif pour faire comprendre la constitution possible de la puce constituant le coeur d'un senseur monolithique.

Dans l'art antérieur, cette puce serait montée dans un boîtier de la manière représentée à la figure 2.

Le boîtier est par exemple un boîtier de céramique multicouche 30 présentant une cavité dans le fond de laquelle est collée ou soudée la puce. La puce est reliée aux broches extérieures 32 du composant par l'intermédiaire de fils de connexion souples 34 soudés entre les plots de contact 14 de la puce et des plages conductrices 36 faisant partie d'un ensemble de conducteurs sérigraphiés et cocuits dans le boîtier de céramique, ces conducteurs étant reliés aux broches extérieures 32. La cavité est fermée par un couvercle 38 transparent aux rayons infra rouge et de préférence opaque aux rayons lumineux, par exemple un couvercle de germanium filtrant les longueurs d'onde au dessous de 2 micromètres.

Cette structure de l'art antérieur est, comme on l'a dit plus haut, très sensible aux contraintes mécaniques subies par le composant. Ces contraintes se traduisent par une perturbation des signaux représentant l'image thermique détectée par le senseur.

Le montage du senseur selon un mode de réalisation préféré de l'invention est représenté en coupe à la figure 3.

On utilise un boîtier qui peut être de même nature que celui de la figure 2, c'est-à-dire par exemple en céramique multicouche. Il a de préférence des dimensions normalisées, notamment en hauteur, de manière à pouvoir être monté sur une carte de circuit imprimé d'une manière tout-à-fait standard.

La puce est de préférence collée ou soudée par des moyens classiques (colle conductrice, soudure eutectique, soudure à l'argent "silver-glass", etc.) sur une plaquette de support 40, mince et rigide, qui peut être en céramique métallisée ou même en métal conducteur (molybdène ou alliage à base d'invar revêtu de cuivre).

Cette plaquette 40 repose sur une feuille mince 42 d'un matériau déformable élastiquement, par exemple une feuille souple de silicone de quelques centaines de micromètres d'épaisseur.

La puce n'est en contact rigide par ailleurs avec aucun point du boîtier, ni avec aucun point susceptible de transmettre directement ou indirectement les contraintes et vibrations subies par le boîtier.

L'ensemble de la plaquette rigide 40 et de la feuille déformable 42 constitue un système de suspension particulièrement efficace : la plaquette améliore la rigidité de la puce et limite donc les déformations mécaniques de la couche pyroélectrique, et la feuille déformable élastiquement limite la transmission à la puce et donc à la couche pyroélectrique des contraintes subies par le boîtier. Par ailleurs la liaison électrique par fils souples empêche la transmission de contraintes par les fils.

Du fait que la puce est rigidement fixée à la plaquette 40, elle subit une contrainte contrôlée (dépendant de la nature des matériaux de la plaquette et de la puce). Cette contrainte contrôlée établit une référence stable et contrôlée du niveau de noir du signal pyroélectrique. D'autre part, plus l'ensemble de la puce et de la plaquette est rigide, meilleur est le découplage mécanique entre le boîtier (isolé de cet ensemble par la couche déformable 42) et la puce.

La feuille souple 42 peut être percée de trous ou de fentes réparties sur sa surface, pour augmenter sa souplesse : le rapport entre la surface de trous et la surface totale peut aller jusqu'à 50% si on le désire.

On a trouvé expérimentalement que la présence d'une telle feuille pouvait diviser par 30 la composante piézoélectrique du signal électrique fourni par le senseur.

Toutefois, le montage de la figure 3 doit permettre la soudure des fils de connexion 34 entre les plots 14 de la puce et les plages conductrices 36 sérigraphiées et cocuites dans le boîtier. Or cette soudure s'effectue en pratique par ultra-sons, ce qui serait a priori incompatible avec la présence d'un support souple sous la puce.

C'est pourquoi, on a prévu selon l'invention des moyens qui autorisent la soudure, même une soudure de fils d'aluminium par ultra-sons, malgré la présence de la couche déformable 42.

La manière la plus simple de résoudre le problème consiste à prévoir que le fond du boîtier porte des butées 44, par exemple une butée à chaque coin, contre lesquelles peut venir s'appuyer la surface inférieure de la plaquette 40 lorsqu'on exerce sur la surface supérieure de la plaquette la pression nécessaire pour l'opération de soudure des fils sur les plots de contact 14 de la puce. L'application d'une pression sur la plaquette comprime et déforme la feuille souple 42 jusqu'à permettre la mise en contact de la plaquette et des butées. A titre d'exemple indicatif, l'épaisseur E de la feuille souple non comprimée est de quelques centaines de micromètres (par exemple 500 micromètres) et la butée s'élève (à partir du fond du boîtier) d'une hauteur H inférieure d'environ 100 micromètres à l'épaisseur E.

Le jeu E-H ainsi ménagé entre l'épaisseur de la feuille et la hauteur des butées est alors suffisant pour absorber les contraintes en cours d'utilisation sans que la plaquette vienne en contact avec les butées, mais pas trop élevé de sorte que ce jeu disparaît lorsque la pression de maintien de la plaquette pendant la soudure par ultrasons est appliquée à la surface supérieure de la plaquette. La valeur de ce jeu dépend de la souplesse du matériau et de la pression exercée pendant la soudure; il est typiquement de quelques dizaines de micromètres jusqu'à 100 ou 200 micromètres.

La plaquette comporte en principe des parties débordantes par rapport à la puce (par exemple une zone débordante sur toute sa périphérie) de manière qu'un outil de maintien puisse appuyer sur cette partie débordante sans appuyer sur la puce, pendant qu'une tête de soudure ultrasonique vient souder sur les plots de contact 14 de la puce des fils d'aluminium.

Une autre manière de procéder, n'utilisant pas de butées, peut consister à refroidir le composant (puce, boîtier, et feuille souple) jusqu'à une température où la rigidité de la feuille souple devient suffisamment élevée pour supporter sans déformation ou presque la pression exercée par les outils de maintien pendant la soudure des fils de connexion. On fera attention de procéder dans une ambiance suffisamment sèche pour éviter toute condensation de vapeur d'eau incompatible avec la soudure ultrasonique de l'aluminium.

On peut donc procéder à un montage de la puce dans lequel on fixe d'abord la puce sur une plaquette, on place une feuille souple au fond du boîtier et on soude les fils de connexion entre d'une part la puce et d'autre part des plages conductrices faisant partie du boîtier.

Dans des cas exceptionnels, on n'utilisera ni butées au fond de la cavité ni refroidissement pendant la soudure, mais on choisira un matériau dont la souplesse permette à la fois un bon découplage mécanique lors de l'utilisation et une résistance à la pression exercée lors de la soudure.

Enfin, on peut envisager aussi que le blocage de la puce pendant la soudure soit effectué par un outillage spécifique (cales) retiré après l'opération de soudure.

Si la consommation de puissance du senseur est élevée (capteurs matriciels à nombreux points d'image), on pourra charger la feuille souple avec un matériau bon conducteur thermique (cuivre, poudre de nitrure d'aluminium, etc.).

Le montage de composant ainsi décrit est particulièrement adapté à la réalisation de composants à coût réduit, par exemple des imageurs thermiques à senseurs pyroélectriques pour des applications automobiles.

## Revendications

1. Composant électronique monté dans un boîtier (30), comprenant une puce de circuit intégré monolithique (10) raccordée par des fils (34) qui sont soudés d'une part à des plages conductrices (36) du boîtier et d'autre part à des plages de contact (14) de la puce, le boîtier comportant une cavité sur le fond de laquelle est disposée la puce, une couche (42) d'un matériau déformable élastiquement, capable d'absorber sans les transmettre à la puce la majeure partie des déformations du boîtier, étant intercalée entre le fond de la cavité et la puce, la puce n'étant par ailleurs pas reliée au boîtier par des éléments susceptibles de transmettre à la puce des contraintes, déformations, ou vibrations subies par le boîtier.

2. Composant selon la revendication 1, caractérisé en ce que la couche déformable est constituée par une feuille souple d'une épaisseur de quelques centaines de micromètres d'un matériau tel que du silicone.

3. Composant selon la revendication 2, caractérisé en ce que la feuille est percée de fentes ou de trous répartis sur sa surface.

4. Composant selon l'une des revendications 1 à 3, caractérisé en ce que la puce est collée ou soudée sur une plaquette rigide (40) et en ce que la couche déformable est intercalée entre la plaquette et le fond de la cavité du boîtier.

5. Composant selon la revendication 4, caractérisé en ce que la plaquette est une plaquette de céramique métallisée ou une plaquette de métal ou d'alliage métallique conducteur.

6. Composant selon l'une des revendications 4 et 5, caractérisé en ce que le fond de la cavité est pourvu de butées (44) contre lesquelles peut venir s'appuyer la plaquette lorsqu'une pression est exercée sur celle-ci en direction du fond de la cavité, la hauteur des butées étant légèrement inférieure à l'épaisseur de la couche déformable lorsqu'aucune pression n'est exercée sur celle-ci.

7. Composant selon la revendication 6, caractérisé en ce que la différence entre la hauteur des butées et l'épaisseur de la couche déformable non comprimée est suffisamment petite pour que la couche puisse être comprimée par un outil lors de la soudure des fils de connexion, et suffisamment grande pour que la plaquette ne vienne pas en contact avec les butées lors de l'utilisation du composant.

8. Composant selon l'une des revendications 1 à 7, caractérisé en ce que la puce porte une couche pyroélectrique et constitue un senseur d'image pyroélectrique.

9. Procédé de montage d'un composant électronique dans un boîtier, caractérisé en ce qu'on intercale une feuille de matériau souple entre une puce et le fond d'une cavité formée dans un boîtier, puis on soude des fils de connexion entre la puce et le boîtier.

10. Procédé selon la revendication 9, caractérisé en ce que l'on fixe d'abord la puce sur une plaquette rigide avant d'intercaler la feuille souple entre la plaquette et le fond de la cavité.

11. Procédé selon la revendication 10, caractérisé en ce qu'on exerce une pression par un outil pendant l'opération de soudure, en comprimant partiellement la feuille souple jusqu'à ce que la plaquette vienne en contact avec des butées ménagées au fond de la cavité, ces butées limitant la compression de la feuille souple, et on effectue la soudure des fils de connexion pendant que la plaquette est en butée.

12. Procédé selon l'une des revendications 9 et 10, caractérisé en ce que l'on refroidit le composant pendant l'opération de soudure jusqu'à une température où la feuille souple est suffisamment rigide pour permettre l'opération de soudure.

13. Procédé selon l'une des revendications 9 à 12, caractérisé en ce que la puce comporte une couche pyroélectrique et constitue un senseur d'image pyroélectrique.

## Patentansprüche

1. Elektronisches Bauelement, das in einem Gehäuse (30) montiert ist und einen monolithischen integrierten Chip (10) enthält, der über Drähte (34) angeschlossen ist, die einerseits an leitende Bereiche (36) des Gehäuses und andererseits an Kontaktzonen (14) des Chips angeschweißt sind, wobei das Gehäuse einen Hohlraum besitzt, an dessen Boden sich der Chip befindet, wobei eine Schicht (42) aus einem elastisch verformbaren Material, das den größten Teil der Verformung des Gehäuses absorbieren kann, ohne sie auf den Chip weiter zu übertragen, zwischen den Boden des Hohlraums und den Chip eingefügt ist und wobei der Chip ansonsten nicht durch Elemente mit dem Gehäuse verbunden ist, die auf den Chip Kräfte, Verformungen oder Vibrationen übertragen können, denen das Gehäuse unterliegt.

2. Bauelement nach Anspruch 1, dadurch gekennzeichnet, daß die verformbare Schicht von einer nachgiebigen Folie eines Materials wie z.B. Silikon mit einer Dicke von einigen hundert µm gebildet wird.

3. Bauelement nach Anspruch 2, dadurch gekennzeichnet, daß die Folie mit über ihre Fläche verteilten Schlitzen oder Löchern versehen ist.

4. Bauelement nach einem der Ansprüche 1 bis 3, dadurch gekennzeichnet, daß der Chip auf eine steife Platte geklebt oder gelötet ist und daß die verformbare Schicht zwischen die Platte und den Grund des Hohlraums des Gehäuses eingefügt ist.

5. Bauelement nach Anspruch 4, dadurch gekennzeichnet, daß die Platte aus einer mit Metall beschichteten Keramik besteht oder eine Platte aus Metall oder einer leitenden Metallegierung ist.

6. Bauelement nach einem der Ansprüche 4 und 5, dadurch gekennzeichnet, daß der Boden des Hohlraums mit Schultern (44) versehen ist, an denen die Platte anstößt, wenn ein Druck auf diese in Richtung zum Boden des Hohlraums ausgeübt wird, und daß die Höhe der Schultern etwas geringer als die Dicke der verformbaren Schicht ist, wenn kein Druck auf diese ausgeübt wird.

7. Bauelement nach Anspruch 6, dadurch gekennzeichnet, daß der Unterschied zwischen der Höhe der Schultern und der Dicke der nicht komprimierten verformbaren Schicht klein genug ist, damit die Schicht durch ein Werkzeug während des Anschweißens der Anschlußdrähte komprimiert werden kann, und groß genug, damit die Platte nicht mit den Schultern während des Betriebs des Bauelements in Kontakt kommt.

8. Bauelement nach einem der Ansprüche 1 bis 7, dadurch gekennzeichnet, daß der Chip eine pyroelektrische Schicht enthält und einen pyroelektrischen Bildaufnehmer bildet.

9. Verfahren zur Montage eines elektronischen Bauelements in einem Gehäuse, dadurch gekennzeichnet, daß eine Folie aus einem nachgiebigen Material zwischen einen Chip und den Grund eines im Gehäuse ausgebildeten Hohlraums eingefügt ist und daß dann Anschlußdrähte zwischen den Chip und das Gehäuse angeschweißt werden.

10. Verfahren nach Anspruch 9, dadurch gekennzeichnet, daß zuerst der Chip auf einer starren Platte befestigt wird, ehe die nachgiebige Folie zwischen die Platte und den Grund des Hohlraums eingefügt wird.

11. Verfahren nach Anspruch 10, dadurch gekennzeichnet, daß ein Druck durch ein Werkzeug während der Schweißoperation ausgeübt wird, wobei die nachgiebige Folie teilweise komprimiert wird, bis sie mit den am Boden des Hohlraums angebrachten Schultern in Kontakt kommt, und daß diese Schultern die Kompression der nachgiebigen Folie begrenzen, und die Anschlußdrähte angeschweißt werden, während die Platte an den Schultern anliegt.

12. Verfahren nach einem der Ansprüche 9 und 10, dadurch gekennzeichnet, daß das Bauelement während des Verschweißens bis auf eine Temperatur abgekühlt wird, bei der die nachgiebige Folie ausreichend steif wird, um die Schweißoperation zu erlauben.

13. Verfahren nach einem der Ansprüche 9 bis 12, dadurch gekennzeichnet, daß der Chip eine pyroelektrische Schicht enthält und einen pyroelektrischen Bildaufnehmer bildet.

## Claims

1. Electronic component mounted in a package (30), comprising a monolithic integrated-circuit chip (10) attached by wires (34) which are bonded, on the one hand, to conducting areas (36) in the package and, on the other hand, to contact areas (14) on the chip, the package including a cavity on the bottom of which the chip is arranged, a layer (42) of an elastically deformable material, capable of absorbing the major part of the deformations of the package without transmitting them to the chip, being inserted between the bottom of the cavity and the chip, the chip moreover not being connected to the package by elements likely to transmit, to the chip, stresses, deformations or vibrations experienced by the package.

2. Component according to Claim 1, characterized in that the deformable layer is constituted by a flexible sheet, a few hundred microns in thickness, of a material such as silicone.

3. Component according to Claim 2, characterized in that the sheet is pierced with slots or holes distributed over its surface.

4. Component according to one of Claims 1 to 3, characterized in that the chip is cemented or bonded to a rigid plate (40) and in that the deformable layer is inserted between the plate and the bottom of the cavity of the package.

5. Component according to Claim 4, characterized in that the plate is a metallized ceramic plate or a plate of metal or of conducting metallic alloy.

6. Component according to one of Claims 4 and 5, characterized in that the bottom of the cavity is provided with abutments (44) against which the plate can bear when a pressure is exerted on the latter in the direction of the bottom of the cavity, the height of the abutments being slightly less than the thickness of the deformable layer when no pressure is exerted on the latter.

7. Component according to Claim 6, characterized in that the difference between the height of the abutments and the thickness of the uncompressed deformable layer is sufficiently small for the layer to be able to be compressed by a tool during the bonding of the connecting wires, and sufficiently large for the plate not to come into contact with the abutments when the component is being used.

8. Component according to one of Claims 1 to 7, characterized in that the chip carries a pyroelectric layer and constitutes a pyroelectric image sensor.

9. Method of mounting an electronic component in a package, characterized in that a sheet of flexible material is inserted between a chip and the bottom of a cavity formed in a package, and then connecting wires are bonded between the chip and the package.

10. Method according to Claim 9, characterized in that the chip is firstly fixed to a rigid plate before inserting the flexible sheet between the plate and the bottom of the cavity.

11. Method according to Claim 10, characterized in that a pressure is exerted by a tool during the bonding operation, partially compressing the flexible sheet until the plate comes into contact with the abutments made at the bottom of the cavity, these abutments limiting the compression of the flexible sheet, and the bonding of the connecting wires is performed while the plate is in abutment.

12. Method according to one of Claims 9 and 10, characterized in that the component is cooled during the bonding operation down to a temperature at which the flexible sheet is sufficiently rigid to permit the bonding operation.

13. Method according to one of Claims 9 to 12, characterized in that the chip includes a pyroelectric layer and constitutes a pyroelectric image sensor.
